# EUROPEAN PATENT APPLICATION

(11) **EP 4 727 318 A1**
(43) Date of publication of application: **15.04.2026**
(21) Application number: 23959164.7
(22) Date of filing: 22.11.2023
(51) Int. Cl.: H10K 71/70, H10K 59/82

(54) **DISPLAY PANEL AND DISPLAY APPARATUS**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: LIAO, Maoying, Beijing 100176 (CN); WANG, Wei, Beijing 100176 (CN); XU, Peng, Beijing 100176 (CN); WEI, Liheng, Beijing 100176 (CN); WANG, Yiding, Beijing 100176 (CN); LIANG, Ke, Beijing 100176 (CN)
(74) Representative: Brötz, Helmut
(86) International application number: PCT/CN2023/133352
(87) International publication number: WO 2025/107190

(57) **Abstract**

Provided are a display panel and a display apparatus. The display panel comprises: a display area, and a peripheral area surrounding the display area. The peripheral area comprises a wiring area, the wiring area being located at one side of the display area. The wiring area is provided with an input area and a dummy area, the dummy area and the input area being arranged in sequence along a direction away from the display area, the input area being provided with multiple input protrusions, and the dummy area being provided with multiple dummy protrusions. The display panel further comprises a substrate, and multiple signal lines located on the substrate. A first spacing area is provided between the multiple input protrusions and the multiple dummy protrusions, and at most one of the multiple signal lines passes through the first spacing area. Thus, in the binding process of an integrated circuit, cracks in an inorganic insulating layer can be reduced or avoided, and defects caused by cracks in the inorganic insulating layer can be avoided.

## Description

### TECHNICAL FIELD

At least one embodiment of the present disclosure relates to a display panel and a display device.

### BACKGROUND

With the application expansion of the flexible organic light-emitting diode (OLED) screens, foldable products have gradually occupied the market in recent years.

### SUMMARY

At least one embodiment of the present disclosure provides a display panel and a display device.

At least one embodiment of the present disclosure provides a display panel, including: a display region and a peripheral region surrounding the display region; the peripheral region includes a wiring region, and the wiring region is located on one side of the display region; the wiring region has an input region and a dummy region, the dummy region and the input region are sequentially arranged in a direction away from the display region, the input region has a plurality of input bumps, and the dummy region has a plurality of dummy bumps; the display panel further includes a base substrate and a plurality of signal lines located on the base substrate, and a first interval region is provided between the plurality of input bumps and the plurality of dummy bumps, and at most one of the plurality of signal lines passes through the first interval region.

For example, according to the display panel provided by at least one embodiment of the present disclosure, one of the plurality of signal lines passes through the first interval region.

For example, according to the display panel provided by at least one embodiment of the present disclosure, the plurality of signal lines include a crack detection line and a source test line, the crack detection line is located in the peripheral region, the crack detection line is configured to detect a crack in the display panel, the source test line is configured to perform a source test, and one of the crack detection line and the source test line passes through the first interval region.

For example, according to the display panel provided by at least one embodiment of the present disclosure, the one of the crack detection line and the source test line includes an extension portion, the extension portion passes through the first interval region, and a minimum distance between the extension portion and the input region is smaller than the minimum distance between the extension portion and the dummy region.

For example, according to the display panel provided by at least one embodiment of the present disclosure, the minimum distance between the extension portion and the input region is 14 to 17 microns.

For example, according to the display panel provided by at least one embodiment of the present disclosure, the wiring region further includes an output region, the output region is located on a side of the dummy region away from the input region, and the output region has a plurality of output bumps, the plurality of input bumps and the plurality of output bumps of the display panel are all configured to be connected with an integrated circuit, and the display panel further includes a plurality of connection bumps located on one side of the wiring region away from the display region, the plurality of connection bumps are configured to be connected with a flexible circuit board, at least part of the plurality of input bumps are arranged in a row in a first direction, and at least part of the plurality of dummy bumps are arranged in a column in a second direction, both the first direction and the second direction are parallel with the base substrate, and the first direction intersects with the second direction.

For example, according to the display panel provided by at least one embodiment of the present disclosure, the plurality of signal lines do not pass through the first interval region.

For example, according to the display panel provided by at least one embodiment of the present disclosure, the plurality of signal lines include a crack detection line and a source test line, the crack detection line is located in the peripheral region, the crack detection line is configured to detect a crack in the display panel, and the source test line is configured to perform a source test, the plurality of connection bumps include a first connection bump and a second connection bump, and two end portions of the crack detection line are connected with the first connection bump and the second connection bump, respectively, the wiring region is located in a region surrounded by the crack detection line, and the wiring region is spaced apart from the crack detection line.

For example, according to the display panel provided by at least one embodiment of the present disclosure, the plurality of connection bumps further include a third connection bump and a fourth connection bump, the third connection bump is connected with the first connection bump, the fourth connection bump is connected with the second connection bump, and the third connection bump and the fourth connection bump are respectively connected with two input bumps in the input region.

For example, according to the display panel provided by at least one embodiment of the present disclosure, the display panel further includes a first test pad and a second test pad, the first test pad is connected with the first connection bump, and the second test pad is connected with the second connection bump, and the first test pad and the second test pad are configured to be connected with a test component for crack detection.

For example, according to the display panel provided by at least one embodiment of the present disclosure, the plurality of dummy bumps include a first dummy bump and a second dummy bump, the first dummy bump and the second dummy bump are adjacent to each other in the second direction, and the source test line passes through a region between the first dummy bump and the second dummy bump.

For example, according to the display panel provided by at least one embodiment of the present disclosure, the first dummy bump is located at an end portion of the dummy region close to the input region.

For example, according to the display panel provided by at least one embodiment of the present disclosure, the plurality of output bumps are arranged in a matrix of M rows and N columns in the first direction and the second direction, and the matrix includes output bumps arranged in M rows and N columns, the output bump in an *i*^{th} row is farther away from the dummy region than the output bump in an (*i*+1)^{th} row, N and M are positive integers, and i is less than or equal to M-1, one end of the source test line is connected with one of the plurality of output bumps, and the other end of the source test line is connected with one of the plurality of connection bumps in the display panel.

For example, according to the display panel provided by at least one embodiment of the present disclosure, the source test line does not pass through the dummy region, and the source test line avoids the first interval region.

For example, according to the display panel provided by at least one embodiment of the present disclosure, the one end of the source test line is connected with one end, away from the dummy region, of one of the plurality of output bumps in a first row of output bumps, and extends to a position away from the wiring region for wiring.

For example, according to the display panel provided by at least one embodiment of the present disclosure, the one end of the source test line is connected with one end, close to the dummy region, of one of the output bumps in the M^{th} row of output bumps, a second interval region is between the plurality of output bumps and the plurality of dummy bumps, and the source test line passes through the second interval region.

For example, according to the display panel provided by at least one embodiment of the present disclosure, the plurality of signal lines further include a plurality of first signal lines, at least a part of each of the plurality of first signal lines extends in the first direction and is located between the input region and the output region, and the first signal line includes a first stacked structure in a direction perpendicular to the base substrate.

For example, according to the display panel provided by at least one embodiment of the present disclosure, the display panel includes a base substrate, and a first conductive pattern, a second conductive pattern, a third conductive pattern, a fourth conductive pattern, and a fifth conductive pattern that are sequentially arranged on the base substrate, and the first conductive pattern is closer to the base substrate than the second conductive pattern, the plurality of signal lines further include a plurality of second signal lines, at least a part of each of the plurality of second signal lines extends in the second direction, the plurality of second signal lines are located on one side of the wiring region in the first direction, and one end of the second signal line is connected with one of the plurality of connection bumps in the display panel, the first signal line is located in the third conductive pattern or in the fifth conductive pattern, and the second signal line is located in the fourth conductive pattern.

For example, according to the display panel provided by at least one embodiment of the present disclosure, the second signal line includes a second stacked structure in the direction perpendicular to the base substrate.

For example, according to the display panel provided by at least one embodiment of the present disclosure, the first stacked structure and/or the second stacked structure include a Ti/Al/Ti structure.

For example, according to the display panel provided by at least one embodiment of the present disclosure, the display panel further includes an organic pattern which includes an opening, the display panel further includes a support structure located in the opening, and the support structure includes an organic material.

For example, according to the display panel provided by at least one embodiment of the present disclosure, the organic pattern includes a first organic pattern, a second organic pattern, and a third organic pattern which are sequentially stacked in the direction perpendicular to the base substrate, and the first organic pattern is closer to the base substrate than the second organic pattern, the first organic pattern includes a first opening, the second organic pattern includes a second opening, the third organic pattern includes a third opening, and the display panel includes an opening region exposed by the first opening, the second opening, and the third opening, the display panel further includes a plurality of support structures located in the opening region.

For example, according to the display panel provided by at least one embodiment of the present disclosure, the support structure is located between the first signal line and the plurality of the input bumps, the support structure includes a first organic structure, a second organic structure, and a third organic structure which are sequentially stacked in the direction perpendicular to the base substrate, the first organic structure is located in the first organic pattern, the second organic structure is located in the second organic pattern, and the third organic structure is located in the third organic pattern.

For example, according to the display panel provided by at least one embodiment of the present disclosure, an orthographic projection of the first organic structure on the base substrate falls into an orthographic projection of the second organic structure on the base substrate, and the orthographic projection of the second organic structure on the base substrate falls into an orthographic projection of the third organic structure on the base substrate.

For example, according to the display panel provided by at least one embodiment of the present disclosure, the second organic structure covers the first organic structure, and the third organic structure covers the second organic structure.

At least one embodiment of the present disclosure further provides a display panel including: a display region and a peripheral region surrounding the display region, the peripheral region includes a wiring region, and the wiring region is located on one side of the display region, the display panel further includes a base substrate and a plurality of signal lines located on the base substrate, the plurality of signal lines include a crack detection line and a source test line, the crack detection line is located in the peripheral region and surrounds the display region, the crack detection line is configured to detect a crack in the display panel, and the source test line is configured to perform a source test, the wiring region has an input region and a dummy region, the dummy region and the input region are sequentially arranged in a direction away from the display region, the input region has a plurality of input bumps, and the dummy region has a plurality of dummy bumps, a first interval region is between the plurality of input bumps and the plurality of dummy bumps, and at most one of the crack detection line and the source test line passes through the first interval region.

For example, according to the display panel provided by at least one embodiment of the present disclosure, the wiring region further includes an output region, the output region is located on a side of the dummy region away from the input region, and the output region has a plurality of output bumps, the plurality of input bumps and the plurality of output bumps of the display panel are all configured to be connected with an integrated circuit, and the display panel further includes a plurality of connection bumps located on one side of the wiring region away from the display region, the plurality of connection bumps are configured to be connected with a flexible circuit board, at least part of the plurality of input bumps are arranged in a row in a first direction, and at least part of the plurality of dummy bumps are arranged in a column in a second direction, both the first direction and the second direction are parallel with the base substrate, and the first direction intersects with the second direction.

For example, according to the display panel provided by at least one embodiment of the present disclosure, the plurality of connection bumps include a first connection bump and a second connection bump, and two end portions of the crack detection line are connected with the first connection bump and the second connection bump, respectively, the wiring region is located in a region surrounded by the crack detection line, and the wiring region is spaced apart from the crack detection line.

For example, according to the display panel provided by at least one embodiment of the present disclosure, the source test line does not pass through the dummy region, and the source test line avoids the first spacer region.

At least one embodiment of the present disclosure further provides a display device, including any one of the display panels as described above.

### BRIEF DESCRIPTION OF DRAWINGS

In order to clearly illustrate the technical solution of the embodiments of the present disclosure, the drawings of the embodiments will be briefly described in the following; it is obvious that the described drawings are only related to some embodiments of the present disclosure and thus are not construed as any limitation to the present disclosure.
Fig. 1 is a schematic diagram of a display panel with not-good result on crack detection.
Fig. 2 is a schematic diagram of a simulation model of a display panel.
Fig. 3 is a schematic diagram of a simulation result of the simulation model in Fig. 2.
Fig. 4 is a schematic diagram of a partial structure of a display panel.
Fig. 5A is a schematic diagram of a simulation result of a display panel.
Fig. 5B is a schematic diagram of a simulation result of another display panel.
Fig. 6 is a schematic diagram of a simulation result of another display panel.
Fig. 7 is a schematic diagram of a display panel (after IC bonding) provided by an embodiment of the present disclosure.
Fig. 8 is a schematic diagram of a wiring region of a display panel provided by an embodiment of the present disclosure.
Fig. 9 is a schematic diagram of a partial structure of a display panel.
Fig. 10 is a schematic diagram of the overall structure of the display panel corresponding to Fig. 9.
Fig. 11 is a partially enlarged schematic view of the display panel corresponding to Fig. 9.
Fig. 12 is a schematic diagram of a wiring region of another display panel provided by an embodiment of the present disclosure.
Fig. 13 is a schematic diagram of the overall structure of the display panel corresponding to Fig. 12.
Fig. 14 is a schematic diagram of a wiring region of another display panel provided by an embodiment of the present disclosure.
Fig. 15 is a schematic diagram of the overall structure of the display panel corresponding to Fig. 14.
Fig. 16 is a schematic diagram of a wiring region of another display panel provided by an embodiment of the present disclosure.
Fig. 17 is a schematic diagram of the overall structure of the display panel corresponding to Fig. 16.
Fig. 18 is a schematic diagram of the overall structure of yet another display panel provided by an embodiment of the present disclosure.
Fig. 19 is a schematic diagram of the overall structure of another display panel provided by an embodiment of the present disclosure.
Fig. 20 is a schematic diagram of a partial structure of a display panel.
Fig. 21 is a schematic diagram of a partial structure of another display panel provided by an embodiment of the present disclosure.
Fig. 22 is a schematic diagram of a support structure provided by an embodiment of the present disclosure.

### DETAILED DESCRIPTION

In order to make objects, technical details and advantages of the embodiments of the present disclosure more clear, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment (s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the present disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "right," "left" and the like are only used to indicate relative position relationship, and when the position of the described object is changed, the relative position relationship may be changed accordingly.

After flexible OLED is applied to foldable products, the quality of the screen in terms of image quality and flicker needs to be further improved. For OLED display products, they can be upgraded from a Low Temperature Poly-Silicon (LTPS) type to a Low Temperature Polycrystalline-Oxide (LTPO) type to meet the higher image quality requirements of the foldable products. In the display field, compared with a 40nm IC chip, a 28nm IC chip is smaller in size and has lower power consumption, so the gradual use of the 28nm IC chip has become an industry trend.

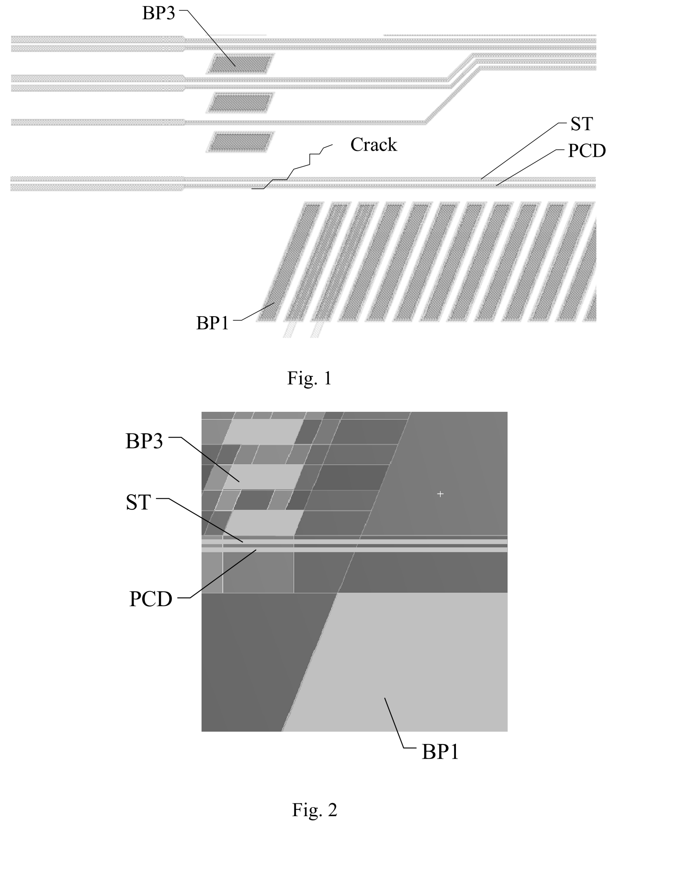

Fig. 1 is a schematic diagram of a display panel with not-good result on crack detection.

As illustrated in Fig. 1, during the production process of the foldable products, the production line continues to have a 3%-7% rate of Not-Good (NG) in display panel crack detection (PCD). After analysis, it was found that a crack was generated in the bonding process of the integrated circuit (IC). For example, a region of the display panel that is bonded to the IC is provided with an input bump BP1 and a dummy bump BP3, a crack detection line PCD passes through the region of the display panel between the input bump BP1 and the dummy bump BP3. In response to the crack extending in this region, the display panel cracks in this region, and the crack will cause the crack detection line in the region used to bond the IC to break, which will cause the display panel crack detection to fail. Therefore, the display panel crack detection NG problem is essentially the crack caused by IC bonding.

In the study, the inventor of this application found that for the foldable LTPO display panel, the not-good result on crack detection caused by the bonding process continued to occur, and obvious cracks were visible under a microscope. The NG rate of different batches are in a range from about 3% to about 7%. The not-good result on crack detection caused by the IC bonding process has two risks for OLED screens: (1) the crack detection of the display panel has been NG, which will cause cracks in other peripheral positions of the display panel unable to be detected; (2) because the essence of the not-good result on crack detection of the display panel is that cracks are present in the display panel, there is a risk of further diffusion and deterioration with the passage of time or the change of reliability, which will affect the normal display of the screen. That is, because the display panel has the cracks, it may cause related defects caused by the cracks, which are not limited to the NG of the crack detection of the display panel.

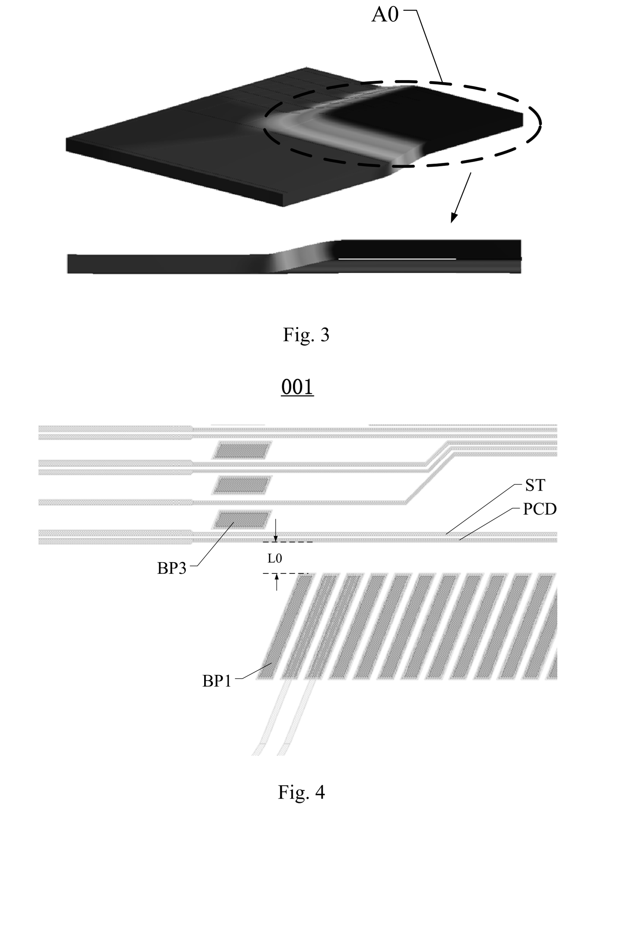

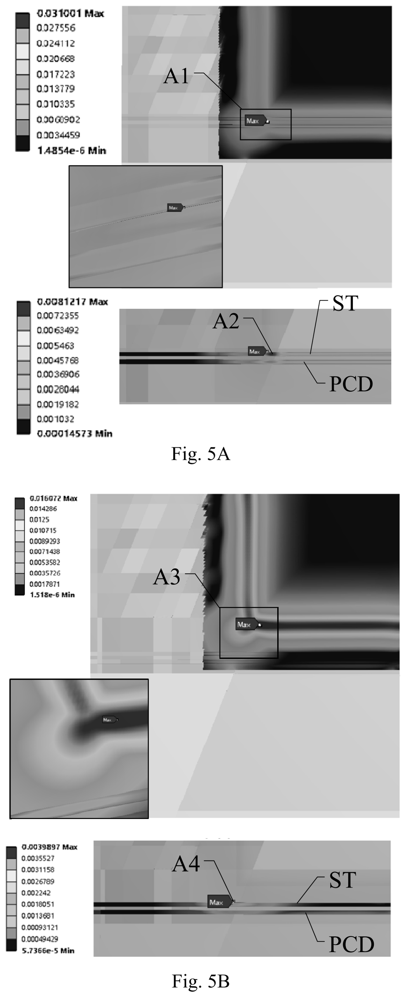

Fig. 2 is a schematic diagram of a simulation model of a display panel; Fig. 3 is a schematic diagram of a simulation result of the simulation model in Fig. 2; Fig. 4 is a schematic diagram of a partial structure of a display panel; Fig. 5A is a schematic diagram of a simulation result of a display panel; Fig. 5B is a schematic diagram of a simulation result of another display panel.

As illustrated in Fig. 2, for a packaging region of the display panel, for example, in a COP (Chip on Pi) region, the constructed simulation model includes an input bump BP1 and a dummy bump BP3, and the crack detection line PCD and the source test line ST both pass through the region between the input bump BP1 and the dummy bump BP3 of the display panel, and the simulation model simplifies the structure in this region. For example, the region between the input bump BP1 and the dummy bump BP3 of the display panel is located in the lower left corner of the display panel. For example, the input bump BP1 and the dummy bump BP3 are both located in the region of the display panel for bonding with the IC, and the input bump BP1 is a conductive structure of the display panel, which is connected with the IC; the dummy bump BP3 is not connected with the IC. For example, the display panel may further include other conductive structures (for example, an output bump) to connect with the IC.

According to Fig. 3, the stress distribution of the simulation model is uneven, and the stress of a region A0 of the display panel between the input bump BP1 and the dummy bump BP3 is significantly larger, so the risk of cracks to generate in the region A0 is higher. This simulation result is highly consistent with the crack-generating region of the actual product, which can explain that the simulation result is authentic.

For example, the simulation model illustrated in Fig. 2 may correspond to the display panel 001 illustrated in Fig. 4. For example, as illustrated in Fig. 4, the crack detection line PCD is closer to the input bump BP1 than the source test line ST, and both the crack detection line PCD and the source test line ST pass through the region between the input bump BP1 and the dummy bump BP3, and the minimum distance L0 between the input bump BP1 and the portion of the crack detection line PCD passing through the region is 58 microns.

As illustrated in Fig. 4 and Fig. 5A, in the region between the input bump BP1 and the dummy bump BP3, in the case where the minimum distance L0 between the crack detection line PCD and the input bump BP1 is 58 microns, the region of the display panel 001 with the largest stress is a region A1, and the maximum stress in region A1 is about 31‰. The portion of the display panel 001 through which the source test line ST passes has a position A2 with the largest stress, and the strain value of the position A2 reaches about 8.1‰, that is, the source test line ST just passes through the position of the display panel 001 with the largest stress where an inorganic layer "climbs".

The difference between the display panel corresponding to Fig. 5B and the display panel corresponding to Fig. 5A is that the minimum distance between the crack detection line PCD and the input bump BP1 is different. For example, referring to Fig. 4, the crack detection line PCD and the source test line ST both pass through the region between the input bump BP1 and the dummy bump BP3, and the minimum distance L0 between the input bump BP1 and the portion of the crack detection line PCD passing through the region can be 14 microns, in this case, as illustrated in Fig. 5B, a region of the display panel with the largest stress is a region A3, and the maximum strain value in the region A3 is about 16‰, the portion of the display panel 001 through which the source test line ST passes has a position A4 with the largest stress, and the strain value of position A4 is about 4.0‰.

It can be seen that by reducing the minimum distance L0 between the input bump BP1 and the portion of the crack detection line PCD passing through the region between the input bump BP1 and the dummy bump BP3, it is beneficial to reducing the strain value of the display panel.

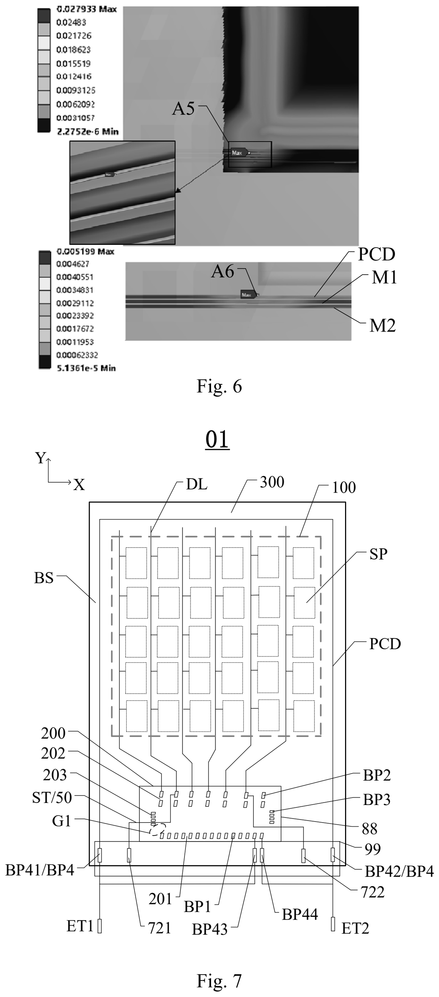

Fig. 6 is a schematic diagram of a simulation result of another display panel.

For example, as illustrated in Fig. 6, in the display panel, three signal lines are arranged in the region between the input bump and the dummy bump, namely, the crack detection line PCD, the data-writing control signal line M1 and the light-emitting control signal line M2. The crack detection line PCD, the data-writing control signal line M1, and the light-emitting control signal line M2 all pass through the region between the input bump and the dummy bump, and the minimum distance between the input bump and the portion of the light-emitting control signal line M2 passing through the region is 22 microns.

According to Fig. 6, a region of the display panel with the largest stress is a region A5, and the maximum strain value in the region A5 is about 27.9‰. The portion of the display panel through which the crack detection line PCD passes has a position A6 with the largest stress, and the strain value at the position A6 is about 5.2‰. The simulation result of this display panel is better than that of the display panel 001, but the overall strain value of the display panel is still at a relatively high level.

According to the above simulation analysis results, it can be seen that the wiring manner in the bonding region of the display panel corresponding to the IC (for example, the region between the input bump and the dummy bump) is very important, which affects the force distribution of the display panel. Therefore, in order to reduce the probability of NG on crack detection of the display panel, it is of great significance to optimize the wiring manner of the region of the display panel bonded with the IC.

At least one embodiment of the present disclosure provides a display panel and a display device.

At least one embodiment of the present disclosure provides a display panel, which includes a display region and a peripheral region surrounding the display region, the peripheral region includes a wiring region, the wiring region is located on one side of the display region; the wiring region has an input region and a dummy region, the dummy region and the input region are sequentially arranged in a direction away from the display region, the input region has a plurality of input bumps, the dummy region has a plurality of dummy bumps, and the display panel further comprises a base substrate and a plurality of signal lines located on the base substrate, a first interval region is provided between the plurality of input bumps and the plurality of dummy bumps, and at most one of the plurality of signal lines passes through the first interval region.

The embodiment of the present disclosure optimizes the arrangement of the signal lines in the first interval region of the display panel so that at most one of the plurality of signal lines passes through the first interval region, which can significantly reduce the strain value in the first interval region, thereby reducing the deformation of the display panel, and achieving the effect of reducing or eliminating cracks caused by the bonding process.

The display panel and the display device provided by the embodiment of the present disclosure are described below in conjunction with the accompanying drawings.

Fig. 7 is a schematic diagram of a display panel (after IC bonding) provided by an embodiment of the present disclosure.

As illustrated in Fig. 7, a display panel 01 includes a display region 100 and a peripheral region 300 surrounding the display region 100. For example, the display region 100 includes a plurality of sub-pixels SP, and the plurality of sub-pixels SP are arranged in an array in the first direction X and the second direction Y. For example, the embodiment of the present disclosure takes the case where the peripheral region 300 surrounds the display region 100 as an example, but is not limited thereto. The peripheral region 300 may be located on at least one side of the display region 100. For example, the peripheral region 300 may be located on at least one of the left side, the right side, the upper side, and the lower side of the display region 100.

As illustrated in Fig. 7, the peripheral region 300 includes a wiring region 200, and the wiring region 200 is located on one side of the display region 100, that is, the wiring region 200 is located on one side of the plurality of sub-pixels SP. Fig. 7 takes the case where the wiring region 200 is located on the lower side of the display region 100 as an example. The wiring region 200 is a part of the peripheral region 300. For the sake of clarity, Fig. 7 does not illustrate all structures and wirings of the display panel 01.

As illustrated in Fig. 7, the display panel 01 further includes a base substrate BS and a plurality of signal lines 50 located on the base substrate BS. For example, the plurality of signal lines 50 are located in the peripheral region 300. For example, the signal line 50 may be connected with a scan line located in the display region 100.

For example, as illustrated in Fig. 7, the plurality of signal lines 50 may include a crack detection line PCD and a source test line ST. The crack detection line PCD is located in the peripheral region 300, and the crack detection line PCD surrounds the display region 100, the crack detection line PCD is configured to detect a crack in the display panel 01, and the source test line ST is configured to perform a source test.

As illustrated in Fig. 7, the wiring region 200 has an input region 201 and a dummy region 203, and the dummy region 203 and the input region 201 are sequentially arranged in a direction away from the display region 100. For example, the input region 201 and the dummy region 203 are sequentially arranged in a second direction Y, and the dummy region 203 is located on the side of the input region 201 close to the display region 100. The input region 201 has a plurality of input bumps BP1, and the dummy region 203 has a plurality of dummy bumps BP3. For example, the wiring region 200 further has an output region 202. In the embodiment of the present disclosure, the division of the output region 201, the input region 202, and the dummy region 203 can be based on lines connecting the outermost edges of the bumps therein.

For example, as illustrated in Fig. 7, at least a part of the plurality of input bumps BP1 are arranged in a row in a first direction X, and at least a part of the plurality of dummy bumps BP3 are arranged in a column in the second direction Y. For example, in some embodiments, at least a part of the plurality of input bumps BP1 can also be arranged in a plurality of rows in the first direction X, and at least a part of the plurality of dummy bumps BP3 can also be arranged in a plurality of columns in the second direction Y.

For example, the first direction X and the second direction Y are both parallel with the base substrate BS, and the first direction X intersects with the second direction Y. For example, the first direction X is perpendicular to the second direction Y.

For example, as illustrated in Fig. 7, the output region 202 is located on a side of the dummy region 203 away from the input region 201, and the output region 202 has a plurality of output bumps BP2. The plurality of input bumps BP1 and the plurality of output bumps BP2 in the display panel 01 are configured to be connected with an integrated circuit 88. For example, the dummy bump BP3 can balance the stress in the bonding process of the integrated circuit 88. The display panel 01 further includes a plurality of connection bumps BP4, which are located on a side of the wiring region 200 away from the display region 100, and the plurality of connection bumps BP4 are configured to be connected with a flexible circuit board 99.

For example, as illustrated in Fig. 7, the display panel 01 includes a plurality of conductive structures and a plurality of connection structures, such as bumps. For example, the plurality of conductive structures may include the input bump BP1, the dummy bump BP3, and the output bump BP2. The plurality of connection structures may include the connection bump BP4. Fig. 7 further illustrates the integrated circuit 88 and the flexible circuit board 99. For example, the integrated circuit 88 and the flexible circuit board 99 may be bonded to the display panel, respectively. For example, the integrated circuit 88 can be bonded to the conductive structures on the display panel 01, such as the input bump BP1 and the output bump BP2. For example, the flexible circuit board 99 can be bonded to the connection structures on the display panel, such as the connection bumps BP4. For example, the bump bonded to the flexible circuit board 99 in the display panel 01 can be connected with the bump bonded to the integrated circuit 88 in the display panel 01. For example, the integrated circuit 88 can be a 28nm IC chip to have a smaller size and lower power consumption.

For example, as illustrated in Fig. 7, both ends of the crack detection line PCD can be connected with the connection bumps BP4 respectively, and then connected with the two input bumps BP1 respectively. For example, whether the crack detection line PCD is broken can be determined by detecting the resistance. In response to the crack detection line PCD being not broken, its resistance is a normal value of the wiring resistance, and in response to the crack detection line PCD is broken, its resistance will be very large.

Fig. 7 further illustrates a data line DL. The data line DL is configured to provide a data signal, such as a data voltage, to the sub-pixel SP. The number of data lines DL is not limited to that illustrated in Fig. 7, which can be determined as needed. One end of the source test line ST is connected with one data line DL through the output bump BP1, and the other end of the source test line ST is connected with the connection structure BP4. Fig. 7 illustrates two source test lines ST, which are respectively connected with a connection bump 721 and a connection bump 722. The connection bump 721 and the connection bump 722 can be respectively connected with the conductive structures on the flexible circuit board 99.

For example, as illustrated in Fig. 7, the source test line ST is mainly used to test whether the data line DL connected thereto is normal. For example, the waveform on the data line DL connected with the source test line ST can be tested through the source test line ST. When the display panel displays abnormally, a source test can be performed to determine whether the display abnormality is caused by a problem with the data line DL.

As illustrated in Fig. 7, a first interval region G1 is provided between the plurality of input bumps BP1 and the plurality of dummy bumps BP3, and at most one of the plurality of signal lines 50 in the display panel 01 passes through the first interval region G1. For example, one of the plurality of signal lines 50 passes through the first interval region G1, or none of the plurality of signal lines 50 passes through the first interval region G1.

For example, as illustrated in Fig. 7, at most one of the crack detection line PCD and the source test line ST passes through the first interval region G1. That is, one of the crack detection line PCD and the source test line ST may pass through the first interval region G1. For example, neither the crack detection line PCD nor the source test line ST passes through the first interval region G1.

In the embodiments of the present disclosure, a signal line (for example, the crack detection line PCD or the source test line ST) does not pass through the first interval region G1 refers to that the signal line avoids the first interval region G1.

With this arrangement, the stress distribution in the first interval region G1 can be effectively improved, and the maximum strain value in the first interval region G1 can be reduced, which can reduce or avoid the cracks in the inorganic insulating layer in the integrated circuit bonding process, and thereby avoiding the defects caused by the cracks in the inorganic insulating layer. For example, it can avoid the cracks in the inorganic insulating layer from causing the breakage of the crack detection line of the display panel, and avoid the failure of the crack detection of the display panel.

The embodiment of the present disclosure optimizes the wiring manner of the signal lines in the COP region of the display panel to reduce the strain value of the COP region (for example, the first interval region G1) and avoid the defects caused by the cracks in the inorganic insulating layer in the display panel.

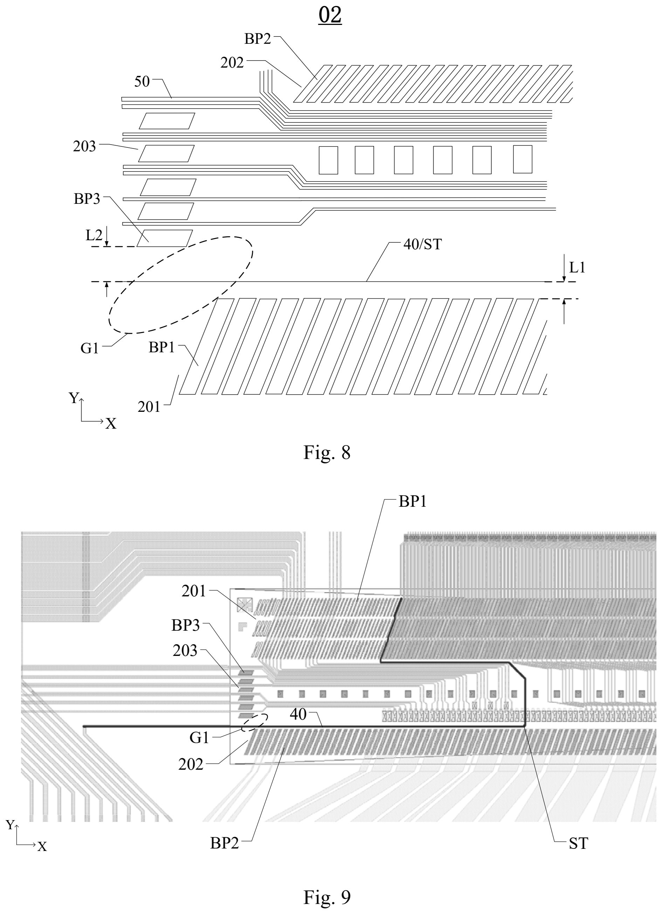

Fig. 8 is a schematic diagram of a wiring region of a display panel provided by an embodiment of the present disclosure.

For example, as illustrated in Fig. 7 and Fig. 8, one of the plurality of signal lines 50 passes through the first interval region G1. For example, one of the plurality of signal lines 50 located in the peripheral region 300 passes through the first interval region G1. For example, the signal line 50 passing through the first interval region G1 may be one of the crack detection line PCD and the source test line ST, or may be another signal line 50 other than the crack detection line PCD and the source test line ST, the embodiment of the present disclosure does not limit the type of the signal line 50 passing through the first interval region G1.

For example, as illustrated in Fig. 7 and Fig. 8, the inorganic insulating layer of the display panel at least includes a portion located in the first interval region G1. By only allowing one signal line 50 to pass through the first interval region G1, the strain value in the first interval region G1 can be effectively reduced, and defects caused by cracks in the inorganic insulating layer in the display panel 01 can be avoided.

For example, as illustrated in Fig. 8, the crack detection line PCD or the source test line ST passes through the first interval region G1, and the crack detection line PCD or the source test line ST passing through the first interval region G1 includes an extension portion 40. The extension portion 40 extends in the first direction X, and the extension portion 40 passes through the first interval region G1. For example, the extension portion 40 may be a part of the crack detection line PCD or a part of the source test line ST, and this part is located between the input region 201 and the dummy region 203 in the second direction Y.

For example, as illustrated in Fig. 8, in the second direction Y, the dummy region 203, the extension portion 40 and the input region 201 are sequentially arranged, and the minimum distance L1 between the extension portion 40 and the input region 201 is less than the minimum distance L2 between the extension portion 40 and the dummy region 203. That is, in the second direction Y, the extension portion 40 is located between the input region 201 and the dummy region 203, and the extension portion 40 is closer to the input region 201.

For example, as illustrated in Fig. 8, in the second direction Y, the minimum distance L1 between the extension portion 40 and the input region 201 is 1/5 to 1/2, for example, at least one of 1/5 to 1/4, 1/5 to 1/3, 1/4 to 1/3 and 1/3 to 1/2, of the minimum distance L2 between the extension portion 40 and the dummy region 203. For example, the extension portion 40 can be as close to the input region 201 as possible to avoid passing through the middle portion of the first interval region G1.

With this arrangement, the extension portion 40 can be avoided from passing through the region of the first interval region G1 that is prone to cracks (for example, the region between the middle portion of the first interval region G1 and the dummy region 203), and the strain value in the first interval region G1 can be effectively reduced to avoid defects caused by the cracks in the inorganic insulating layer in the display panel 02.

For example, as illustrated in Fig. 8, in the second direction Y, the minimum distance between the extension portion 40 and the input region 201 can be 14 to 17 microns, for example, 14 to 15 microns, 14 to 16 microns, 15 to 16 microns, 15 to 17 microns, or 16 to 17 microns, which can be set according to design requirements.

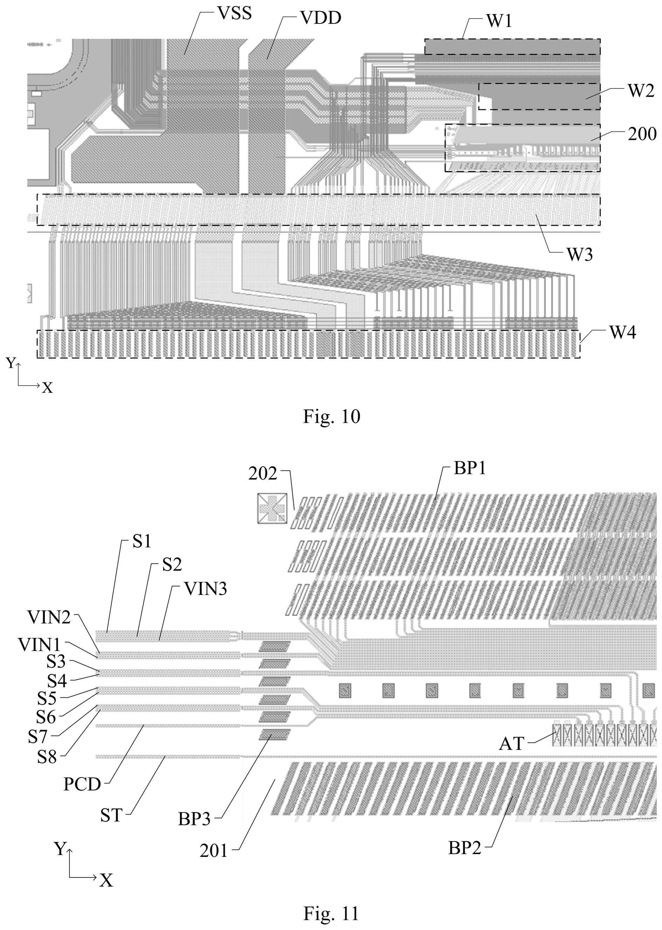

Fig. 9 is a schematic diagram of a partial structure of a display panel; Fig. 10 is a schematic diagram of the overall structure of the display panel corresponding to Fig. 9; and Fig. 11 is a partially enlarged schematic view of the display panel corresponding to Fig. 9.

For example, as illustrated in Fig. 9, the signal line passing through the first interval region G1 can be the source test line ST. For example, one end of the source test line ST is connected with the input bump BP1 in the input region 201, and one end of the source test line ST can be connected with the connection bump. The portion of the source test line ST located between the dummy region 203 and the input region 201 (for example, the extension portion 40) basically extends along the edge of the input region 201, thereby avoiding excessive bending of the extension region 40 and balancing the stress distribution between the dummy region 203 and the input region 201. Other structures of the display panel illustrated in Fig. 9 can refer to the relevant descriptions of Fig. 7 and Fig. 8 in the above embodiments, which are not repeated here.

For example, as illustrated in Fig. 10, the display panel may include a gathering region W1, a gathering region W2, a wiring region 200, a pad region W3, and a test region W4 that are sequentially arranged in the second direction Y. For example, a plurality of signal lines respectively connected with a plurality of scan lines in the display region are gathered in the gathering region W1, and then gathered in the gathering region W2. A plurality of connection bumps are arranged in the pad region W3 to connect with the flexible circuit board. A plurality of test pads are arranged in the test region W4, the test pad is connected with a test component, so that the state of the signal line corresponding to the test pad can be detected. For example, the display panel may further include a first voltage signal line VDD and a second voltage signal line VSS, for example, the first voltage signal line VDD may be a power signal line, and the second voltage signal line VSS may be grounded.

For example, as illustrated in Fig. 11, in the second direction Y, the display panel may include a signal line S1, a signal line S2, an initialization signal line VIN3, an initialization signal line VIN2, an initialization signal line VIN1, a signal line S3, a signal line S4, a signal line S5, a signal line S6, a signal line S7, and a signal line S8. For example, the initialization signal line VIN3, the initialization signal line VIN2, and the initialization signal line VIN1 may all transmit initialization signals. For example, the signal line S1, the signal line S2, the signal line S3, the signal line S4, the signal line S5, the signal line S6, the signal line S7, and the signal line S8 are respectively configured to transmit different control signals.

For example, as illustrated in Fig. 11, the display panel further includes a test pad AT, and a plurality of signal lines located between the input region 201 and the output region 202 are respectively connected with a plurality of test pads AT. The test pad AT is configured to be connected with a test component for signal detection.

For example, as illustrated in Fig. 7, the plurality of connection bumps BP4 include a first connection bump BP41 and a second connection bump BP42, and the two ends of the crack detection line PCD are connected with the first connection bump BP41 and the second connection bump BP42, respectively. The wiring region 200 is located in the region surrounded by the crack detection line PCD, and the wiring region 200 is spaced apart from the crack detection line PCD.

For example, as illustrated in Fig. 7, in the first direction X, the first connection bump BP41 and the second connection bump BP42 are respectively located on both sides of the wiring region 200. In the second direction Y, the first connection bump BP41 and the second connection bump BP42 are both located on the side of the wiring region 200 away from the display region 100. For example, the first connection bump BP41 and the second connection bump BP42 do not overlap with the wiring region 200. For example, the crack detection line PCD surrounds the wiring region 200. With this arrangement, the crack detection line PCD can avoid the wiring region 200, thereby avoiding the first interval region G1 in the wiring region 200, so that the crack detection line PCD does not pass through the first interval region G1, thereby reducing the strain value in the first interval region G1, reducing the crack detection NG problem of the display panel 01, and avoiding the defects caused by the cracks of the inorganic insulating layer in the display panel 01.

For example, as illustrated in Fig. 7, the plurality of connection bumps BP4 in the display panel 01 further include a third connection bump BP43 and a fourth connection bump BP44, the third connection bump BP43 is connected with the first connection bump BP41, the fourth connection bump BP44 is connected with the second connection bump BP42, the third connection bump BP43 and the fourth connection bump BP44 are respectively connected with the two input bumps BP1 in the input region 201, so that the crack detection line PCD can be electrically connected with the two input bumps BP1 in the input region 201.

For example, as illustrated in Fig. 7, in the first direction X, the third connection bump BP43 and the fourth connection bump BP44 may be located between the first connection bump BP41 and the second connection bump BP42, the third connection bump BP43 is closer to the wiring region 200 than the first connection bump BP41, and the fourth connection bump BP44 is closer to the wiring region 200 than the second connection bump BP42, so that the third connection bump BP43 and the fourth connection bump BP44 can be conveniently connected with the input bumps BP1 in the wiring region 200. For example, the third connection bump BP43 and the fourth connection bump BP44 may be connected with two adjacent input bumps BP1 in the wiring region 200, respectively. For example, the two input bumps BP1 respectively connected with the third connection bump BP43 and the fourth connection bump BP44 are both away from the first interval region G1. For example, the two input bumps BP1 respectively connected with the third connection bump BP43 and the fourth connection bump BP44 can be located in the middle portion of the input region 201, so as to reduce the strain value in the first interval region G1 and reduce the crack detection NG problem of the display panel.

Of course, in some embodiments of the present disclosure, the third connection bump BP43 can further be located on the side of the first connection bump BP41 away from the input region 201, and the fourth connection bump BP44 can further be located on the side of the second connection bump BP42 away from the input region 201, which can be set according to the space of the layout.

For example, as illustrated in Fig. 7, the display panel 01 further includes a first test pad ET1 and a second test pad ET2, the first test pad ET1 is connected with the first connection bump BP41, the second test pad ET2 is connected with the second connection bump BP42, and the first test pad ET1 and the second test pad ET2 are configured to be connected with the test component for crack detection.

For example, as illustrated in Fig. 7, the first test pad ET1 can be connected with the first connection bump BP41 through a wire lead, and the second test pad ET2 can be connected with the second connection bump BP42 through a wire lead, so that the first test pad ET1 and the second test pad ET2 can be connected with the crack detection line PCD. For example, the test component can include probes, and the probes can be connected with the first test pad ET1 and the second test pad ET2 respectively to detect the resistance of the crack detection line PCD, so that whether the crack detection line PCD being broken can be determined.

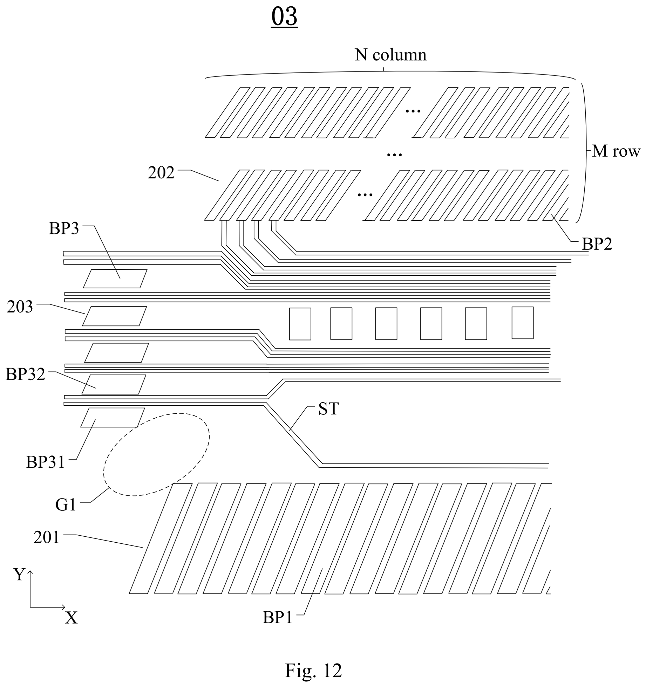

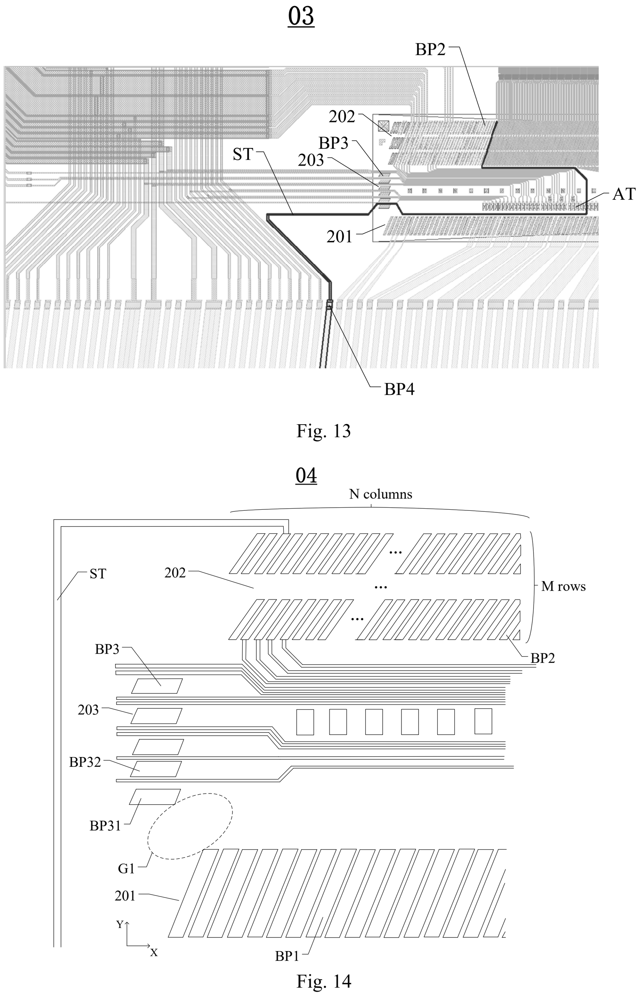

Fig. 12 is a schematic diagram of a wiring region of another display panel provided by an embodiment of the present disclosure; Fig. 13 is a schematic diagram of the overall structure of the display panel corresponding to Fig. 12.

For example, as illustrated in Fig. 12, the crack detection line PCD and the source test line ST do not pass through the first interval region G1. For example, the crack detection line PCD can adopt the wiring manner illustrated in Fig. 7, but the embodiment of the present disclosure is not limited thereto. For example, as illustrated in Fig. 12, the source test line ST can be located on a side of at least one dummy bump BP3 away from the input region 201 to avoid the first interval region G1.

For example, as illustrated in Fig. 12, the plurality of dummy bumps BP3 may include a first dummy bump BP31 and a second dummy bump BP32, the first dummy bump BP31 and the second dummy bump BP32 are adjacent to each other in the second direction Y, and the source test line ST passes through the region between the first dummy bump BP31 and the second dummy bump BP32. Therefore, the source test line ST can bypass the first interval region G1 to reduce the maximum strain value of the first interval region G1, and reduce the crack detection NG problem of the display panel 03.

For example, as illustrated in Fig. 12, the plurality of dummy bumps BP3 are sequentially arranged in the second direction Y, and the first dummy bump BP31 is located at the end portion of the dummy region 203 close to the input region 201. For example, the plurality of dummy bumps BP3 may be sequentially arranged in one column or a plurality of columns in the second direction Y, and the embodiment of the present disclosure is not limited thereto. For example, in the second direction Y, the first dummy bump BP31 is closer to the input region 201 than the second dummy bump BP32. For example, in the second direction Y, the first dummy bump BP31 may be the dummy bump closest to the input region 201 in the dummy region 203. For example, the first dummy bump BP31 and the second dummy bump BP32 being adjacent to each other in the second direction Y refers to that in the second direction Y, no other dummy bump BP3 is arranged between the first dummy bump BP31 and the second dummy bump BP32.

With this arrangement, a crossing between the source test line ST and other signal lines passing through the dummy region 203 can be minimized while the source test line ST avoids the first interval region G1, so that the risk of signal crosstalk can be reduced and the layout arrangement can be more reasonable.

For example, as illustrated in Fig. 12, a plurality of output bumps BP2 are arranged in a matrix of M rows and N columns in the first direction X and the second direction Y, and the matrix includes output bumps BP2 arranged in M rows and N columns. For example, the output bump BP2 of the *i*^{th} row is farther away from the dummy region 203 than the output bump BP2 of the (*i*+*1*)^{th} row, N and M are both positive integers, and *i* is less than or equal to M-1. For example, the output bump BP2 of the first row is farther away from the dummy region 203 than the output bump BP2 of the second row. For example, the output bump BP2 of the M^{th} row is closer to the dummy region 203 than the output bump BP2 of the (M-1)^{th} row.

For example, as illustrated in Fig. 12 and Fig. 13, one end of the source test line ST is connected with one of the plurality of output bumps BP2, and the other end of the source test line ST is connected with one of the plurality of connection bumps BP4 in the display panel 03. The source test line ST extends from the output region 202 to the region close to the test pad AT, and then extends in the first direction X to the region close to the dummy region 203. The source test line ST passes through the dummy region 203 and passes through the region between two adjacent dummy bumps BP3 of the dummy region 203, and then connects with the connection bump BP4.

For other structures in the display panel illustrated in Fig. 12 and Fig. 13, please refer to the relevant description of Fig. 7 and Fig. 8 in the above embodiments, which are not be repeated here.

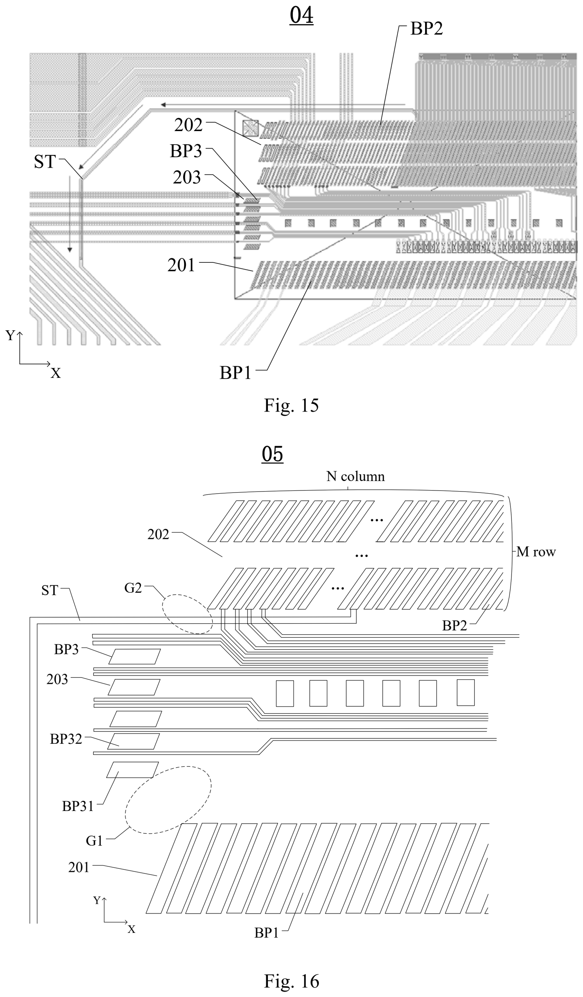

Fig. 14 is a schematic diagram of a wiring region of another display panel provided by an embodiment of the present disclosure; Fig. 15 is a schematic diagram of the overall structure of the display panel corresponding to Fig. 14.

For example, as illustrated in Fig. 14, the difference between the display panel 04 and the display panel 03 in Fig. 12 is that the wiring manner of the source test line ST is different, and other structures are the same, or substantially the same. For details, please refer to the relevant descriptions of the above embodiments, which are not be repeated here.

For example, as illustrated in Fig. 14, the arrangement manner of the crack detection line PCD in the display panel 04 can be the same as that of the display panel 01 illustrated in Fig. 7. The source test line ST in the display panel 04 does not pass through the dummy region 203, and the source test line ST avoids the first interval region G1. For example, in the first direction X, a part of the source test line ST is located on one side of the dummy region 203, and there is a spacing between the source test line ST and the dummy region 203. For example, in the first direction X, the minimum distance between the source test line ST and the dummy region 203 is smaller than the minimum distance between the source test line ST and the input region 201, and there is a spacing between the source test line ST and the first interval region G1, so that the source test line ST can avoid the first interval region G1 to improve the stress distribution in the first interval region G1, and solve the problem that the source test line ST is broken in the first interval region G1.

For example, as illustrated in Fig. 14 and Fig. 15, one end of the source test line ST is connected with one end of one of the plurality of output bumps BP2 in the first row of output bumps BP2 in the output region 202 away from the dummy region 203, and the source test line ST extends to a position away from the wiring region 200 for wiring. For example, one end of the source test line ST is connected with one end of one of the output bumps BP2 in the first row of output bumps BP2 away from the dummy region 203, and then extends in the first direction X toward the region away from the test pad AT to be away from the wiring region 200. Furthermore, the source test line ST extends in the second direction Y. This arrangement facilitates the connection of one end of the source test line ST and the output bump BP2, so that the source test line ST can be avoided from overlapping with other output bumps BP2 in the output region 202, the risk of signal crosstalk can be reduced, and the layout arrangement the can be facilitated.

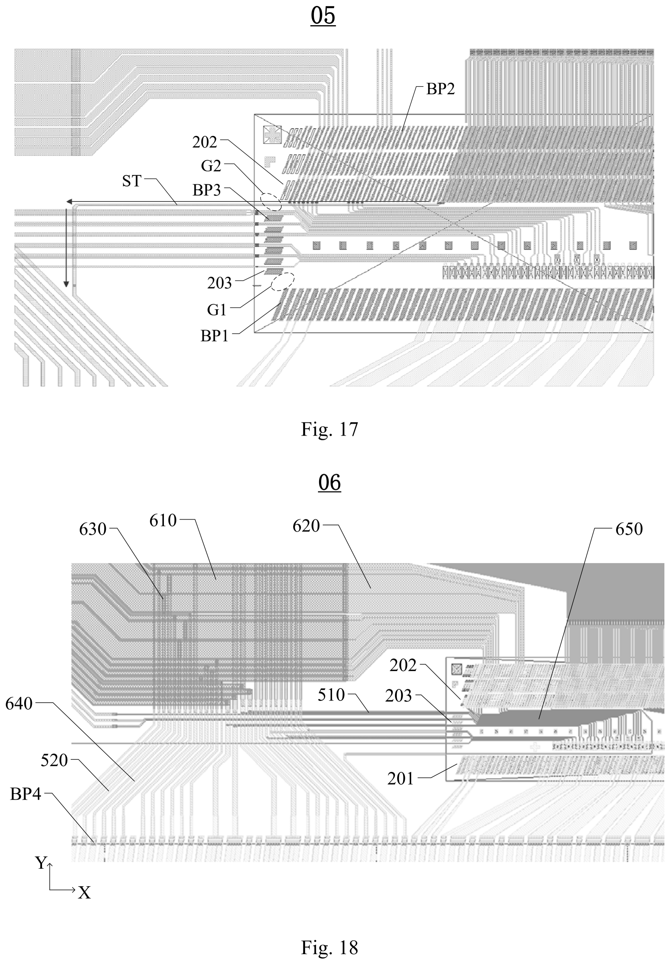

Fig. 16 is a schematic diagram of a wiring region of another display panel provided by an embodiment of the present disclosure; Fig. 17 is a schematic diagram of the overall structure of the display panel corresponding to Fig. 16.

For example, as illustrated in Fig. 16, the difference between the display panel 05 and the display panel 04 in Fig. 14 is that the wiring manner of the source test line ST is different, and other structures are the same or substantially the same. For details, please refer to the relevant descriptions of the above embodiments, which are not be repeated here.

For example, as illustrated in Fig. 16, one end of the source test line ST can be connected with one end of one of the plurality of output bumps BP2 in the M^{th} row of output bumps BP2 close to the dummy region 203, and there is a second interval region G2 between the plurality of output bumps BP2 and the plurality of dummy bumps BP3, and the source test line ST passes through the second interval region G2. For example, one end of the source test line ST can be connected with one of the output bumps BP2 in the M^{th} row of output bumps BP2, and connected with one end of the output bump BP2 close to the dummy region 203. With this arrangement, the source test line ST can be avoided from overlapping with other output bumps BP2 in the output region 202, so as to reduce the risk of signal crosstalk and facilitate the layout arrangement.

For example, as illustrated in Fig. 16 and Fig. 17, the source test line ST extends along the edge of the output region 202 close to the dummy region 203, passes through the second interval region G2, and then extends to one side of the dummy region 203, and then extends in the second direction Y, and finally connects with the connection bump of the display panel 05. Therefore, the source test line ST can avoid the dummy region 203 and the first interval region G1, the stress distribution in the first interval region G1 can be improved, and the problem of the source test line ST breaking in the first interval region G1 is solved.

For example, as illustrated in Fig. 16, the plurality of signal lines 50 in the display panel 05 do not pass through the first interval region G1, that is, any signal line 50 does not pass through the first interval region G1, therefore, the stress distribution in the first interval region G1 can be improved and the problem of any signal line 50 breaking in the first interval region G1 is solved.

For example, for the display panels illustrated in Fig. 15 and Fig. 17, after the source test line ST is led out from the output region 202, the source test line ST can be connected with the connection bump of the display panel after avoiding the dummy region 203, and the position of the connection bump can refer to the connection bump BP4 in Fig. 13, that is, it is located on the side of the input region 201 away from the output region 202.

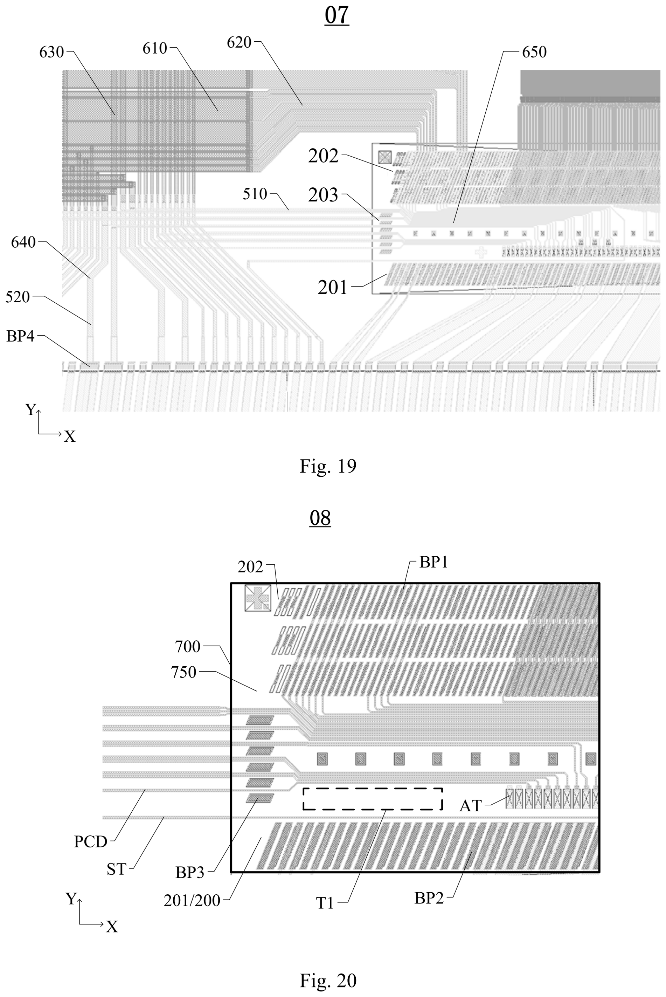

Fig. 18 is a schematic diagram of the overall structure of yet another display panel provided by an embodiment of the present disclosure; Fig. 19 is a schematic diagram of the overall structure of another display panel provided by an embodiment of the present disclosure.

For example, as illustrated in Fig. 18, the plurality of signal lines 50 further include a plurality of first signal lines 510, at least a portion of the first signal line 510 extends in the first direction X, and the first signal line 510 is located between the input region 201 and the output region 202. For example, the first signal line 510 passes through the dummy region 203. For example, the first signal line 510 passes through the region between two adjacent dummy bumps BP2. For example, the first signal line 510 may be any one of the signal line S1, the signal line S2, the initialization signal line VIN3, the initialization signal line VIN2, the initialization signal line VIN1, the signal line S3, the signal line S4, the signal line S5, the signal line S6, the signal line S7, and the signal line S8 illustrated in Fig. 11.

For example, as illustrated in Fig. 18, the first signal line 510 includes a first stacked structure in a direction perpendicular to the base substrate. For example, the first stacked structure may be a Ti/Al/Ti structure in the direction perpendicular to the base substrate, but the embodiments of the present disclosure are not limited thereto. The first signal line 510 adopts such a structure, so that the unit area resistance of the first signal line 510 can be reduced. For example, the unit area resistance of the first signal line 510 adopting the first stacked structure can be 0.004~0.006Ω/µm², such as 0.005Ω/µm², which is conducive to reducing the load of the first signal line 510. In the embodiment of the present disclosure, the unit area resistance of the signal line refers to the resistance of the signal line per square micron of the projection area of the signal line on the base substrate.

For example, as illustrated in Fig. 18, the plurality of signal lines 50 further include a plurality of second signal lines 520, at least a part of the second signal line 520 extends in the second direction Y, the plurality of second signal lines 520 are located on one side of the wiring region 200 in the first direction X, and one end of the second signal line 520 is connected with the connection bump BP4 in the display panel. For example, one end of the second signal line 520 can be connected with the first signal line 510, and the other end of the second signal line 520 can be connected with the connection bump BP4. For example, the first signal line 510 can be connected with the second signal line 520 through a via hole penetrating the insulating layer.

For example, as illustrated in Fig. 18, the second signal line 520 includes a second stacked structure in the direction perpendicular to the base substrate. For example, the second stacked structure may also be a Ti/Al/Ti structure in the direction perpendicular to the base substrate, but the embodiments of the present disclosure are not limited thereto. For example, the second stacked structure may be the same as the first stacked structure, or the second stacked structure may be different from the first stacked structure. The second signal line 520 adopts such a structure, the unit area resistance of the second signal line 520 can be reduced. For example, the unit area resistance of the second signal line 520 adopting the second stacked structure may be 0.004~0.006Ω/µm², such as 0.005Ω/µm², which is beneficial to reducing the load of the second signal line 520.

For example, as illustrated in Fig. 18, the display panel may include a base substrate, and a first conductive pattern 610, a second conductive pattern 620, a third conductive pattern 630, a fourth conductive pattern 640, and a fifth conductive pattern 650 that are sequentially arranged on the base substrate, the first conductive pattern 610 is closer to the base substrate than the second conductive pattern 620. For example, the second conductive pattern 620 is located between the first conductive pattern 610 and the third conductive pattern 630. For example, an inorganic insulating layer may be provided between the first conductive pattern 610 and the second conductive pattern 620, for example, the inorganic insulating layer may be a passivation layer, but is not limited thereto.

For example, as illustrated in Fig. 18, the materials of the first conductive pattern 610 and the second conductive pattern 620 may be the same, for example, molybdenum may be used. For example, the third conductive pattern 630, the fourth conductive pattern 640, and the fifth conductive pattern 650 may be made of the same material, for example, the third conductive pattern 630, the fourth conductive pattern 640, and the fifth conductive pattern 650 may all include a Ti/Al/Ti structure, but are not limited thereto.

For example, as illustrated in Fig. 18, the first signal line 510 may be located in the third conductive pattern 630, but the embodiments of the present disclosures are not limited thereto.

For example, as illustrated in Fig. 19, the difference between the display panel 07 and the display panel 06 in Fig. 18 is that the wiring manner of the first signal line 510 is different, and the other structures are the same or substantially the same. For details, please refer to the relevant descriptions of the above embodiments, which are not be repeated here.

For example, as illustrated in Fig. 19, the first signal line 510 may be located in the fifth conductive pattern 650 to reduce the unit area resistance of the first signal line 510.

For example, as illustrated in Fig. 18 and Fig. 19, the second signal line 520 may be located in the fourth conductive pattern 640 to reduce the unit area resistance of the second signal line 520.

Fig. 20 is a schematic diagram of a partial structure of a display panel.

For example, as illustrated in Fig. 20, compared with the display panel 02 illustrated in Fig. 8, the display panel 08 further includes an organic pattern 700, and the other structures are the same or substantially the same, which are not be repeated here.

For example, as illustrated in Fig. 20, the organic pattern 700 includes an opening 750, and the opening 750 can expose the wiring region 200. In the region defined by the opening 750, the organic pattern 700 is removed. For example, the wiring region 200 includes a flat region T1, and no structure for supporting the structure (for example, the dummy bump BP3) is provided in the flat region T1. Therefore, the strain and pressure of the flat region T1 are large, and cracks and other defects are easily generated.

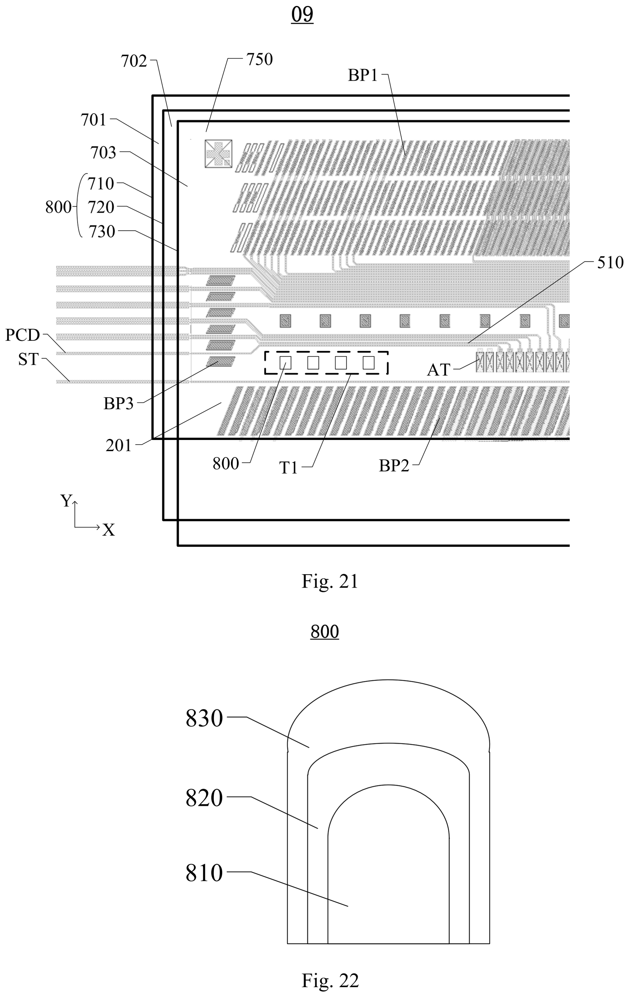

Fig. 21 is a schematic diagram of a partial structure of another display panel provided by an embodiment of the present disclosure; Fig. 22 is a schematic diagram of a support structure provided by an embodiment of the present disclosure.

For example, as illustrated in Fig. 21, compared with the display panel 08 illustrated in Fig. 20, the display panel 09 further includes a support structure, and other structures are the same, or substantially the same, which are not repeated here.

For example, as illustrated in Fig. 21, the display panel 09 further includes a support structure 800 located in the opening 750, and the support structure 800 includes an organic material. For example, the support structure 800 is located in the flat region T1, so that the structure located in this region can be supported to reduce the strain and pressure of the flat region T1.

For example, as illustrated in Fig. 22, the organic pattern 700 may include a first organic pattern 710, a second organic pattern 720, and a third organic pattern 730, and the first organic pattern 710, the second organic pattern 720, and the third organic pattern 730 are sequentially stacked in the direction perpendicular to the base substrate, and the first organic pattern 710 is closer to the base substrate than the second organic pattern 720. For example, the second organic pattern 720 is located between the first organic pattern 710 and the third organic pattern 730. For example, the first organic pattern 710, the second organic pattern 720, and the third organic pattern 730 may include the same insulating material.

For example, as illustrated in Fig. 21, the first organic pattern 710 includes a first opening 701, the second organic pattern 720 includes a second opening 702, and the third organic pattern 730 includes a third opening 703. For example, the first opening 701, the second opening 702, and the third opening 703 include overlapping regions. The display panel 09 includes an opening region 750 exposed by the first opening 701, the second opening 702, and the third opening 703, and the display panel 09 further includes a plurality of support structures 800 located in the opening region 750. For example, the support structure 800 is located in the flat region T1, so that the structure located in the region can be supported to reduce the strain and pressure of the flat region T1. For example, the support structure 800 can be made of the same material as the first organic pattern 710, the second organic pattern 720, and the third organic pattern 730, and the embodiments of the present disclosure are not limited to this.

For example, as illustrated in Fig. 21 and Fig. 22, the support structure 800 is located between the first signal line 510 and the input bump BP1, for example, the support structure 800 can be located between the crack detection line PCD and the input bump BP1.

For example, as illustrated in Fig. 22, the support structure 800 includes a first organic structure 810, a second organic structure 820, and a third organic structure 830 which are sequentially stacked in the direction perpendicular to the base substrate. The first organic structure 810 is located in the first organic pattern 710, the second organic structure 820 is located in the second organic pattern 720, and the third organic structure 830 is located in the third organic pattern 730. For example, the first organic structure 810 is a part of the first organic pattern 710, the second organic structure 820 is a part of the second organic pattern 720, and the third organic structure 830 is a part of the third organic pattern 730. Therefore, there is no need to form the first organic structure 810, the second organic structure 820, and the third organic structure 830 through additional processes, which is conducive to simplifying the manufacturing process of the first organic structure 810, the second organic structure 820, and the third organic structure 830.

For example, as illustrated in Fig. 22, the orthographic projection of the first organic structure 810 on the base substrate falls into the orthographic projection of the second organic structure 820 on the base substrate, and the orthographic projection of the second organic structure 820 on the base substrate falls into the orthographic projection of the third organic structure 830 on the base substrate. For example, an area of the orthographic projection of the second organic structure 820 may be greater than an area of the orthographic projection of the first organic structure 810, and an area of the orthographic projection of the third organic structure 830 may be greater than an area of the orthographic projection of the second organic structure 820.

For example, as illustrated in Fig. 22, the second organic structure 820 may cover the first organic structure 810, and the third organic structure 830 may cover the second organic structure 820. For example, the outer surface of the first organic structure 810 may be completely covered by the second organic structure 820, and the outer surface of the second organic structure 820 may be completely covered by the third organic structure 830. With this arrangement, it is conducive to forming the second organic structure 820 and the third organic structure 830 by patterning, so that the manufacturing process of the support structure 800 is simpler.

The embodiment of the present disclosure further provides another display panel.

As illustrated in Fig. 7, the display panel 01 includes a display region 100 and a peripheral region 300 surrounding the display region 100. For example, the display region 100 includes a plurality of sub-pixels SP, and the plurality of sub-pixels SP are arranged in an array in the first direction X and the second direction Y. For example, the embodiment of the present disclosure takes the case where the peripheral region 300 surrounds the display region 100 as an example, but is not limited thereto. The peripheral region 300 may be located on at least one side of the display region 100. For example, the peripheral region 300 may be located on at least one of the left side, the right side, the upper side, and the lower side of the display region 100.

As illustrated in Fig. 7, the peripheral region 300 includes a wiring region 200, and the wiring region 200 is located on one side of the display region 100, that is, the wiring region 200 is located on one side of the plurality of sub-pixels SP. Fig. 7 takes the case where the wiring region 200 is located on the lower side of the display region 100 as an example. The wiring region 200 is a part of the peripheral region 300. For the sake of clarity, Fig. 7 does not illustrate all structures and wirings of the display panel 01.

As illustrated in Fig. 7, the display panel 01 further includes a base substrate BS and a plurality of signal lines 50 located on the base substrate BS. For example, the plurality of signal lines 50 are located in the peripheral region 300. For example, the signal line 50 can be connected with a scan line located in the display region 100.

For example, as illustrated in Fig. 7, the plurality of signal lines 50 include a crack detection line PCD and a source test line ST. The crack detection line PCD is located in the peripheral region 300, and the crack detection line PCD surrounds the display region 100, the crack detection line PCD is configured to detect cracks in the display panel 01, and the source test line ST is configured to perform a source test.

As illustrated in Fig. 7, the wiring region 200 has an input region 201 and a dummy region 203, and the dummy region 203 and the input region 201 are sequentially arranged in a direction away from the display region 100. For example, the input region 201 and the dummy region 203 are sequentially arranged in the second direction Y, and the dummy region 203 is located on the side of the input region 201 close to the display region 100. The input region 201 has a plurality of input bumps BP1, and the dummy region 203 has a plurality of dummy bumps BP3.

For example, as illustrated in Fig. 7, for example, the wiring region 200 futher has an output region 202. The output region 202 is located on the side of the dummy region 203 away from the input region 201, and the output region 202 has a plurality of output bumps BP2. The plurality of input bumps BP1 and the plurality of output bumps BP2 on the display panel 01 are configured to be connected with an integrated circuit 88. For example, the dummy bump BP3 can balance the stress in the bonding process of the integrated circuit 88. The display panel 01 further includes a plurality of connection bumps BP4, and the plurality of connection bumps BP4 are located on the side of the wiring region 200 away from the display region 100, and the plurality of connection bumps BP4 are configured to be connected with a flexible circuit board 99.

For example, as illustrated in Fig. 7, the display panel 01 includes a plurality of conductive structures and a plurality of connection structures, such as bumps. For example, the plurality of conductive structures may include an input bump BP1, a dummy bump BP3, and an output bump BP2. The plurality of connection structures may include a connection bump BP4. Fig. 7 further illustrates the integrated circuit 88 and the flexible circuit board 99. For example, the integrated circuit 88 and the flexible circuit board 99 may be respectively bonded to the display panel. For example, the integrated circuit 88 may be bonded to conductive structures on the display panel 01, such as an input bump BP1 and an output bump BP2. For example, the flexible circuit board 99 may be bonded to a connection structure on the display panel, such as a connection bump BP4. For example, a bump on the display panel 01 bonded to the flexible circuit board 99 may be connected with a bump on the display panel 01 bonded to the integrated circuit 88. For example, the integrated circuit 88 may be a 28nm IC chip to have a smaller size and lower power consumption.

For example, as illustrated in Fig. 7, both ends of the crack detection line PCD may be respectively connected with the connection bumps BP4, and then respectively connected with two input bumps BP1. For example, whether the crack detection line PCD is broken can be determined by detecting the resistance. In the case where the crack detection line PCD is not broken, its resistance is a normal value of the wiring resistance, and in the case where the crack detection line PCD is broken, its resistance will be very large.

Fig. 7 also illustrates the data line DL. The data line DL is configured to provide a data signal, such as a data voltage, to the sub-pixel SP. The number of data lines DL is not limited to that illustrated in Fig. 7, which can be determined as needed. One end of the source test line ST is connected with one data line DL through the output bump BP1, and the other end of the source test line ST is connected with the connection structure BP4. Fig. 7 illustrates two source test lines ST, which are respectively connected with a connection bump 721 and a connection bump 722. The connection bump 721 and the connection bump 722 can be respectively connected with the conductive structures on the flexible circuit board 99.

For example, as illustrated in Fig. 7, the source test line ST is mainly used to test whether the data line DL connected thereto is normal. For example, the waveform on the data line DL connected the source test line ST can be tested through the source test line ST. In the case where the display panel displays abnormally, a source test can be performed to determine whether the display abnormality is caused by a problem with the data line DL.

As illustrated in Fig. 7, a first interval region G1 is provided between the plurality of input bumps BP1 and the plurality of dummy bumps BP3, and at most one of the crack detection line PCD and the source test line ST passes through the first interval region G1. That is, one of the crack detection line PCD and the source test line ST can pass through the first interval region G1. For example, neither the crack detection line PCD nor the source test line ST passes through the first interval region G1.

In the embodiments of the present disclosure, a signal line (for example, the crack detection line PCD or the source test line ST) does not pass through the first interval region G1 refers to that the signal line avoids the first interval region G1.

With this arrangement, the stress distribution in the first interval region G1 can be effectively improved, and the maximum strain value in the first interval region G1 can be reduced, which can reduce or avoid the cracks in the inorganic insulating layer in the integrated circuit bonding process, and thereby avoiding the defects caused by the cracks in the inorganic insulating layer. For example, it can avoid the cracks in the inorganic insulating layer from causing the breakage of the crack detection line of the display panel, and avoid the failure of the crack detection of the display panel.

For example, as illustrated in Fig. 7, at least a part of the plurality of input bumps BP1 are arranged in a row in a first direction X, and at least a part of the plurality of dummy bumps BP3 are arranged in a column in the second direction Y. For example, in some embodiments, at least a part of the plurality of input bumps BP1 can also be arranged in a plurality of rows in the first direction X, and at least a part of the plurality of dummy bumps BP3 can also be arranged in a plurality of columns in the second direction Y.

For example, as illustrated in Fig. 7, the plurality of connection bumps BP4 include a first connection bump BP41 and a second connection bump BP42, and the two ends of the crack detection line PCD are connected with the first connection bump BP41 and the second connection bump BP42, respectively. The wiring region 200 is located in the region surrounded by the crack detection line PCD, and the wiring region 200 is spaced apart from the crack detection line PCD.

For example, as illustrated in Fig. 7, in the first direction X, the first connection bump BP41 and the second connection bump BP42 are respectively located on both sides of the wiring region 200. In the second direction Y, the first connection bump BP41 and the second connection bump BP42 are both located on the side of the wiring region 200 away from the display region 100. For example, the first connection bump BP41 and the second connection bump BP42 do not overlap with the wiring region 200. For example, the crack detection line PCD surrounds the wiring region 200.

With this arrangement, the crack detection line PCD can avoid the wiring region 200, thereby avoiding the first interval region G1 in the wiring region 200, so that the crack detection line PCD does not pass through the first interval region G1, thereby reducing the strain value in the first interval region G1, reducing the crack detection NG problem of the display panel 01, and avoiding the defects caused by the cracks of the inorganic insulating layer in the display panel 01.

For example, as illustrated in Fig. 7, the plurality of connection bumps BP4 in the display panel 01 further include a third connection bump BP43 and a fourth connection bump BP44, the third connection bump BP43 is connected with the first connection bump BP41, the fourth connection bump BP44 is connected with the second connection bump BP42, the third connection bump BP43 and the fourth connection bump BP44 are respectively connected with the two input bumps BP1 in the input region 201, so that the crack detection line PCD can be electrically connected with the two input bumps BP1 in the input region 201.

For example, as illustrated in Fig. 7, the source test line ST may not pass through the first interval region G1. For example, the source test line ST may avoid the first interval region G1.

For example, as illustrated in Fig. 12, the plurality of dummy bumps BP3 may include a first dummy bump BP31 and a second dummy bump BP32, the first dummy bump BP31 and the second dummy bump BP32 are adjacent to each other in the second direction Y, and the source test line ST passes through the region between the first dummy bump BP31 and the second dummy bump BP32. Therefore, the source test line ST can bypass the first interval region G1 to reduce the maximum strain value of the first interval region G1, and reduce the crack detection NG problem of the display panel 03.

For example, as illustrated in Fig. 12, a plurality of output bumps BP2 are arranged in a matrix of M rows and N columns in the first direction X and the second direction Y, and the matrix includes output bumps BP2 arranged in M rows and N columns. For example, the output bump BP2 of the *i*^{th} row is farther away from the dummy region 203 than the output bump BP2 of the (*i*+*1*)^{th} row, N and M are both positive integers, and *i* is less than or equal to M-1. For example, the output bump BP2 of the first row is farther away from the dummy region 203 than the output bump BP2 of the second row. For example, the output bump BP2 of the M^{th} row is closer to the dummy region 203 than the output bump BP2 of the (M-1)^{th} row.

For example, as illustrated in Fig. 14 and Fig. 15, one end of the source test line ST is connected with one end of one of the plurality of output bumps BP2 in the first row of output bumps BP2 in the output region 202 away from the dummy region 203, and the source test line ST extends to a position away from the wiring region 200 for wiring.

For example, as illustrated in Fig. 16, one end of the source test line ST can be connected with one end of one of the plurality of output bumps BP2 in the M^{th} row of output bumps BP2 close to the dummy region 203, and there is a second interval region G2 between the plurality of output bumps BP2 and the plurality of dummy bumps BP3, and the source test line ST passes through the second interval region G2.

Therefore, the source test line ST can avoid the first interval region G1 to improve the stress distribution in the first interval region G1 and solve the problem of the source test line ST breaking in the first interval region G1.

The various components or structures in embodiments of the present disclosure may be ordered in the order in which they appear, without having to be restricted to the names with ordinal numbers given in the specification.

The embodiments of the present disclosure further provide a display device, including any of the above-mentioned display panels. For example, the display panel may be a foldable display panel, and the display device may be a foldable display device. Of course, the display panel may be a non-foldable display panel, and the display device may be a non-foldable display device.

For example, the display device includes the OLED, or includes a product including the OLED. For example, the display device includes any product or component with a display function, such as a TV, a digital camera, a mobile phone, a watch, a tablet computer, a laptop computer, a navigator, etc., containing the above display panel.

It should be noted that for the sake of clarity, in the drawings used for describing the embodiments of the present disclosure, the thicknesses of layers or regions are scaled up. It will be understood that when an element such as a layer, a film, a region, or a substrate is referred to as being "on" or "under" another element, the element can be "directly" "on" or "under" another element, or intermediate elements can be present.

The above are only specific implementations of the present disclosure, the protection scope of the present disclosure is not limited thereto. Any changes or substitutions easily occur to those skilled in the art within the technical scope of the present disclosure should be covered in the protection scope of the present disclosure. Therefore, the protection scope of the present disclosure should be based on the protection scope of the claims.

## Claims

1. A display panel, comprising:
a display region and a peripheral region surrounding the display region, wherein the peripheral region comprises a wiring region, and the wiring region is located on one side of the display region,
wherein the wiring region has an input region and a dummy region, the dummy region and the input region are sequentially arranged in a direction away from the display region, the input region has a plurality of input bumps, and the dummy region has a plurality of dummy bumps,
the display panel further comprises a base substrate and a plurality of signal lines located on the base substrate, and a first interval region is provided between the plurality of input bumps and the plurality of dummy bumps, and at most one of the plurality of signal lines passes through the first interval region.

2. The display panel according to claim 1, wherein one of the plurality of signal lines passes through the first interval region.

3. The display panel according to claim 1 or 2, wherein the plurality of signal lines comprise a crack detection line and a source test line, the crack detection line is located in the peripheral region, the crack detection line is configured to detect a crack in the display panel, the source test line is configured to perform a source test, and one of the crack detection line and the source test line passes through the first interval region.

4. The display panel according to claim 3, wherein the one of the crack detection line and the source test line comprises an extension portion, the extension portion passes through the first interval region, and a minimum distance between the extension portion and the input region is smaller than the minimum distance between the extension portion and the dummy region.

5. The display panel according to claim 4, wherein the minimum distance between the extension portion and the input region is 14 to 17 microns.

6. The display panel according to claim 1, wherein the wiring region further comprises an output region, the output region is located on a side of the dummy region away from the input region, and the output region has a plurality of output bumps,
the plurality of input bumps and the plurality of output bumps of the display panel are all configured to be connected with an integrated circuit, and the display panel further comprises a plurality of connection bumps located on one side of the wiring region away from the display region, the plurality of connection bumps are configured to be connected with a flexible circuit board,
at least part of the plurality of input bumps are arranged in a row in a first direction, and at least part of the plurality of dummy bumps are arranged in a column in a second direction, wherein both the first direction and the second direction are parallel with the base substrate, and the first direction intersects with the second direction.

7. The display panel according to claim 6, wherein the plurality of signal lines do not pass through the first interval region.

8. The display panel according to claim 7, wherein the plurality of signal lines comprise a crack detection line and a source test line, the crack detection line is located in the peripheral region, the crack detection line is configured to detect a crack in the display panel, and the source test line is configured to perform a source test,
the plurality of connection bumps comprise a first connection bump and a second connection bump, and two end portions of the crack detection line are connected with the first connection bump and the second connection bump, respectively,
the wiring region is located in a region surrounded by the crack detection line, and the wiring region is spaced apart from the crack detection line.

9. The display panel according to claim 8, wherein the plurality of connection bumps further comprise a third connection bump and a fourth connection bump,
the third connection bump is connected with the first connection bump, the fourth connection bump is connected with the second connection bump, and the third connection bump and the fourth connection bump are respectively connected with two input bumps in the input region.

10. The display panel according to claim 9, further comprising a first test pad and a second test pad,
wherein the first test pad is connected with the first connection bump, and the second test pad is connected with the second connection bump, and the first test pad and the second test pad are configured to be connected with a test component for crack detection.

11. The display panel according to any one of claims 7-10, wherein the plurality of dummy bumps comprise a first dummy bump and a second dummy bump,
the first dummy bump and the second dummy bump are adjacent to each other in the second direction, and the source test line passes through a region between the first dummy bump and the second dummy bump.

12. The display panel according to claim 11, wherein the first dummy bump is located at an end portion of the dummy region close to the input region.

13. The display panel according to any one of claims 7-10, wherein the plurality of output bumps are arranged in a matrix of M rows and N columns in the first direction and the second direction, and the matrix comprises output bumps arranged in M rows and N columns, the output bump in an *i*^{th} row is farther away from the dummy region than the output bump in an (*i*+1)^{th} row, N and M are positive integers, and i is less than or equal to M-1,
one end of the source test line is connected with one of the plurality of output bumps, and the other end of the source test line is connected with one of the plurality of connection bumps in the display panel.

14. The display panel according to claim 13, wherein the source test line does not pass through the dummy region, and the source test line avoids the first interval region.

15. The display panel according to claim 14, wherein the one end of the source test line is connected with one end, away from the dummy region, of one of the plurality of output bumps in a first row of output bumps, and extends to a position away from the wiring region for wiring.

16. The display panel according to claim 14, wherein the one end of the source test line is connected with one end, close to the dummy region, of one of the output bumps in the M^{th} row of output bumps,
a second interval region is between the plurality of output bumps and the plurality of dummy bumps, and the source test line passes through the second interval region.

17. The display panel according to any one of claims 6-16, wherein the plurality of signal lines further comprise a plurality of first signal lines, at least a part of each of the plurality of first signal lines extends in the first direction and is located between the input region and the output region, and the first signal line comprises a first stacked structure in a direction perpendicular to the base substrate.

18. The display panel according to claim 17, wherein the display panel comprises a base substrate, and a first conductive pattern, a second conductive pattern, a third conductive pattern, a fourth conductive pattern, and a fifth conductive pattern that are sequentially arranged on the base substrate, and the first conductive pattern is closer to the base substrate than the second conductive pattern,
the plurality of signal lines further comprise a plurality of second signal lines, at least a part of each of the plurality of second signal lines extends in the second direction, the plurality of second signal lines are located on one side of the wiring region in the first direction, and one end of the second signal line is connected with one of the plurality of connection bumps in the display panel,
the first signal line is located in the third conductive pattern or in the fifth conductive pattern, and the second signal line is located in the fourth conductive pattern.

19. The display panel according to claim 18, wherein the second signal line comprises a second stacked structure in the direction perpendicular to the base substrate.

20. The display panel according to claim 19, wherein the first stacked structure and/or the second stacked structure comprise a Ti/Al/Ti structure.

21. The display panel according to any one of claims 17-20, further comprising an organic pattern which comprises an opening,
wherein the display panel further comprises a support structure located in the opening, and the support structure comprises an organic material.

22. The display panel according to claim 21, wherein the organic pattern comprises a first organic pattern, a second organic pattern, and a third organic pattern which are sequentially stacked in the direction perpendicular to the base substrate, and the first organic pattern is closer to the base substrate than the second organic pattern,
the first organic pattern comprises a first opening, the second organic pattern comprises a second opening, the third organic pattern comprises a third opening, and the display panel comprises an opening region exposed by the first opening, the second opening, and the third opening,
wherein the display panel further comprises a plurality of support structures located in the opening region.

23. The display panel according to claim 22, wherein the support structure is located between the first signal line and the plurality of the input bumps,
the support structure comprises a first organic structure, a second organic structure, and a third organic structure which are sequentially stacked in the direction perpendicular to the base substrate, wherein the first organic structure is located in the first organic pattern, the second organic structure is located in the second organic pattern, and the third organic structure is located in the third organic pattern.

24. The display panel according to claim 23, wherein an orthographic projection of the first organic structure on the base substrate falls into an orthographic projection of the second organic structure on the base substrate, and the orthographic projection of the second organic structure on the base substrate falls into an orthographic projection of the third organic structure on the base substrate.

25. The display panel according to claim 23 or 24, wherein the second organic structure covers the first organic structure, and the third organic structure covers the second organic structure.

26. A display panel comprising:
a display region and a peripheral region surrounding the display region, wherein the peripheral region comprises a wiring region, and the wiring region is located on one side of the display region,
wherein the display panel further comprises a base substrate and a plurality of signal lines located on the base substrate, the plurality of signal lines comprise a crack detection line and a source test line, the crack detection line is located in the peripheral region and surrounds the display region, the crack detection line is configured to detect a crack in the display panel, and the source test line is configured to perform a source test,
wherein the wiring region has an input region and a dummy region, the dummy region and the input region are sequentially arranged in a direction away from the display region, the input region has a plurality of input bumps, and the dummy region has a plurality of dummy bumps,
a first interval region is between the plurality of input bumps and the plurality of dummy bumps, and at most one of the crack detection line and the source test line passes through the first interval region.

27. The display panel according to claim 26, wherein the wiring region further comprises an output region, the output region is located on a side of the dummy region away from the input region, and the output region has a plurality of output bumps,
the plurality of input bumps and the plurality of output bumps of the display panel are all configured to be connected with an integrated circuit, and the display panel further comprises a plurality of connection bumps located on one side of the wiring region away from the display region, the plurality of connection bumps are configured to be connected with a flexible circuit board,
at least part of the plurality of input bumps are arranged in a row in a first direction, and at least part of the plurality of dummy bumps are arranged in a column in a second direction, wherein both the first direction and the second direction are parallel with the base substrate, and the first direction intersects with the second direction.

28. The display panel according to claim 27, wherein the plurality of connection bumps comprise a first connection bump and a second connection bump, and two end portions of the crack detection line are connected with the first connection bump and the second connection bump, respectively,
the wiring region is located in a region surrounded by the crack detection line, and the wiring region is spaced apart from the crack detection line.

29. The display panel according to claim 26 or 28, wherein the source test line does not pass through the dummy region, and the source test line avoids the first spacer region.

30. A display device, comprising the display panel according to any one of claims 1-29.
